# EUROPEAN PATENT APPLICATION

(11) **EP 4 607 593 A1**
(43) Date of publication of application: **27.08.2025**
(21) Application number: 23884178.7
(22) Date of filing: 12.06.2023
(51) Int. Cl.: H01L 25/075

(54) **DISPLAY SCREEN AND PREPARATION METHOD THEREFOR, AND ELECTRONIC DEVICE**

(30) Priority: 01.11.2022 CN 202211356120; 28.12.2022 CN 202211715306
(71) Applicant: Huawei Technologies Co., Ltd., Shenzhen, Guangdong 518129 (CN)
(72) Inventor: LUO, Kun, Shenzhen, Guangdong 518129 (CN); JIANG, Congbiao, Shenzhen, Guangdong 518129 (CN)
(74) Representative: Gill Jennings & Every LLP
(86) International application number: PCT/CN2023/099684
(87) International publication number: WO 2024/093239

(57) **Abstract**

Embodiments of this application provide a display, a manufacturing method thereof, and an electronic device, and relate to the field of display technologies, to improve performance of the display. The display includes a first primary-color light emitting diode, a second primary-color light emitting diode, and a third primary-color light emitting diode that are stacked. The first primary-color light emitting diode includes a first overlapping portion and a first light emission portion. The second primary-color light emitting diode includes a second overlapping portion and a second light emission portion, the second light emission portion covers the first overlapping portion, and the second overlapping portion exposes the first light emission portion. The third primary-color light emitting diode covers the second overlapping portion and exposes the first light emission portion and the second light emission portion. A first primary-color light guide is located on a side that is of the first light emission portion and that faces the second primary-color light emitting diode. A second primary-color light guide is located on a side that is of the second light emission portion and that faces the third primary-color light emitting diode. A third primary-color light guide is located on a light emission side of the third primary-color light emitting diode.

## Description

This application claims priority to Chinese Patent Application No. 202211356120.6, filed with the China National Intellectual Property Administration on November 1, 2022 and entitled "DISPLAY, MANUFACTURING METHOD THEREOF, AND ELECTRONIC DEVICE", and to Chinese Patent Application No. 202211715306.6, filed with the China National Intellectual Property Administration on December 28, 2022 and entitled "DISPLAY, MANUFACTURING METHOD THEREOF, AND ELECTRONIC DEVICE", which are incorporated herein by reference in their entireties.

### TECHNICAL FIELD

This application relates to the field of display technologies, and in particular, to a display, a manufacturing method thereof, and an electronic device.

### BACKGROUND

A display is one of important components of an electronic device having a display function. Light emitting effect and a size of the display directly affect performance and a size of the electronic device.

A micro-light emitting diode (micro-light emitting diode, Micro-LED) is a light emitting diode whose size is less than 100 µm. A high-density display including micro-LEDs has advantages such as high brightness, a small size, a long service life, high contrast, and high resolution, and has become one of focuses in the display field.

However, as the size of the display decreases, it also leads to problems such as low light emitting efficiency and severe crosstalk of the display, thereby affecting performance of the display.

### SUMMARY

Embodiments of this application provide a display, a manufacturing method thereof, and an electronic device, to improve performance of the display.

To achieve the foregoing objective, the following technical solutions are used in this application.

According to a first aspect of embodiments of this application, a display is provided, and the display may be, for example, a micro-light emitting diode display. The display includes: a first primary-color light emitting diode, a second primary-color light emitting diode, and a third primary-color light emitting diode. The first primary-color light emitting diode includes a first overlapping portion and a first light emission portion. The second primary-color light emitting diode is located on a light emission side of the first primary-color light emitting diode. The second primary-color light emitting diode includes a second overlapping portion and a second light emission portion, the second light emission portion covers the first overlapping portion, and the second overlapping portion exposes the first light emission portion. The third primary-color light emitting diode is located on a side that is of the second primary-color light emitting diode and that is away from the first primary-color light emitting diode. The third primary-color light emitting diode covers the second overlapping portion and exposes the first light emission portion and the second light emission portion. The display further includes a first primary-color light guide, a second primary-color light guide, and a third primary-color light guide. The first primary-color light guide is located on a side that is of the first light emission portion and that faces the second primary-color light emitting diode. The second primary-color light guide is located on a side that is of the second light emission portion and that faces the third primary-color light emitting diode. The third primary-color light guide is located on a light emission side of the third primary-color light emitting diode.

According to the display provided in this embodiment of this application, three light emitting diodes are stacked in a thickness direction of the display, so that the three light emitting diodes are arranged in a vertical direction, and a size of the light emitting diode can be increased, to improve light emitting efficiency of the light emitting diode. In addition, the three light emitting diodes are disposed in a staggered manner, no other light emitting diode is disposed above the first light emission portion of the first primary-color light emitting diode, no other light emitting diode is disposed above the second light emission portion of the second primary-color light emitting diode, and no other light emitting diode is disposed above the third primary-color light emitting diode. Therefore, the first primary-color light guide passes through only the first primary-color light emitting diode, the second primary-color light guide passes through only the second primary-color light emitting diode, and the third primary-color light guide passes through only the third primary-color light emitting diode. In this way, a case in which light emitted by a plurality of primary-color light emitting diodes is guided out from a same light guide may be improved, to improve optical crosstalk between the primary-color light emitting diodes (namely, subpixels), and a requirement for high brightness in a high pixel density may be met.

In a possible implementation, the first primary-color light emitting diode includes a first lower electrode, a first epitaxial layer, and a first upper electrode that are sequentially stacked, and a material of the first upper electrode includes metal. The material of the first upper electrode includes metal, so that light emitted by the first primary-color light emitting diode may be reflected back into the first primary-color light emitting diode by the first upper electrode. This can reduce optical interference between the primary-color light emitting diodes and improve light collection efficiency. In addition, the first upper electrode made of the metal material can reduce an operating temperature of the first primary-color light emitting diode, and improve reliability of the first primary-color light emitting diode, thereby improving light emitting efficiency of the first primary-color light emitting diode and resolving a problem of color drifting of the first primary-color light emitting diode.

In a possible implementation, the second primary-color light emitting diode includes a second lower electrode, a second epitaxial layer, and a second upper electrode that are sequentially stacked, and a material of the second upper electrode includes metal. The material of the second upper electrode includes metal, so that light emitted by the second primary-color light emitting diode may be reflected back into the second primary-color light emitting diode by the second upper electrode. This can reduce optical interference between the primary-color light emitting diodes and improve light collection efficiency. In addition, the second upper electrode made of the metal material can reduce an operating temperature of the second primary-color light emitting diode, and improve reliability of the second primary-color light emitting diode, thereby improving light emitting efficiency of the second primary-color light emitting diode and resolving a problem of color drifting of the second primary-color light emitting diode.

In a possible implementation, the third primary-color light emitting diode includes a third lower electrode, a third epitaxial layer, and a third upper electrode that are sequentially stacked, and a material of the third upper electrode includes metal. The material of the third upper electrode includes metal, so that light emitted by the third primary-color light emitting diode may be reflected back into the third primary-color light emitting diode by the third upper electrode. This can reduce optical interference between the primary-color light emitting diodes and improve light collection efficiency. In addition, the third upper electrode made of the metal material can reduce an operating temperature of the third primary-color light emitting diode, and improve reliability of the third primary-color light emitting diode, thereby improving light emitting efficiency of the third primary-color light emitting diode and resolving a problem of color drifting of the third primary-color light emitting diode.

In a possible implementation, the first primary-color light guide extends into the first primary-color light emitting diode. In this way, light emitted by the first primary-color light emitting diode may be emitted from the first primary-color light guide without being exiting the first primary-color light emitting diode, thereby improving light emission efficiency.

In a possible implementation, the second primary-color light guide extends into the second primary-color light emitting diode. In this way, light emitted by the second primary-color light emitting diode may be emitted from the second primary-color light guide without exiting the second primary-color light emitting diode, thereby improving light emission efficiency.

In a possible implementation, the third primary-color light guide extends into the third primary-color light emitting diode. In this way, light emitted by the third primary-color light emitting diode may be emitted from the third primary-color light guide without exiting the third primary-color light emitting diode, thereby improving light emission efficiency.

In a possible implementation, the display further includes a first planarization layer located on the light emission side of the first primary-color light emitting diode; and the first primary-color light guide runs through the first planarization layer, and a refractive index of the first primary-color light guide is greater than a refractive index of the first planarization layer. In this way, light can be emitted from the first primary-color light guide in a total reflection form, to improve light emission effect and light emission efficiency.

In a possible implementation, the display further includes a second planarization layer located on a light emission side of the second primary-color light emitting diode; and the second primary-color light guide runs through the second planarization layer, and a refractive index of the second primary-color light guide is greater than a refractive index of the second planarization layer. In this way, light can be emitted from the second primary-color light guide in a total reflection form, to improve light emission effect and light emission efficiency.

In a possible implementation, the display further includes a third planarization layer located on the light emission side of the third primary-color light emitting diode; and the third primary-color light guide runs through the third planarization layer, and a refractive index of the third primary-color light guide is greater than a refractive index of the third planarization layer. In this way, light can be emitted from the third primary-color light guide in a total reflection form, to improve light emission effect and light emission efficiency.

In a possible implementation, a material of the first primary-color light guide is a transparent material. In this way, light guide effect of the first primary-color light guide can be improved, and a light loss can be reduced.

In a possible implementation, a material of the second primary-color light guide is a transparent material. In this way, light guide effect of the second primary-color light guide can be improved, and a light loss can be reduced.

In a possible implementation, a material of the third primary-color light guide is a transparent material. In this way, light guide effect of the third primary-color light guide can be improved, and a light loss can be reduced.

In a possible implementation, the third primary-color light emitting diode is a blue light emitting diode; and the material of the third primary-color light guide includes a red light conversion material. The blue light emitting diode has high light emitting brightness. Red light required by a pixel unit is provided by converting blue light into red light, so that light emitting brightness of the red light can be improved.

In a possible implementation, the first primary-color light emitting diode, the second primary-color light emitting diode, and the third primary-color light emitting diode are respectively a red light emitting diode, a green light emitting diode, and a blue light emitting diode. When the three primary-color light emitting diodes are respectively three primary color (for example, red, green, and blue) light emitting diodes, the display may implement full-color display.

In a possible implementation, the third primary-color light emitting diode is a red light emitting diode. Due to low light conversion efficiency of red light, when the red light emitting diode is located at the top, an area of a red light subpixel may be increased, to improve overall brightness of the display.

In a possible implementation, the first primary-color light emitting diode further includes a first passivation layer; and the first upper electrode covers a top surface and a side surface of the first epitaxial layer, the first passivation layer is located between the first upper electrode and the first epitaxial layer, a first opening is provided in the first passivation layer, and the first upper electrode is in contact with the first epitaxial layer through the first opening. The first upper electrode covers the top surface and the side surface of the first epitaxial layer, so that an area of the first upper electrode can be increased, and light reflection effect and heat dissipation effect are further improved.

In a possible implementation, the second primary-color light emitting diode further includes a second passivation layer; and the second upper electrode covers a top surface and a side surface of the second epitaxial layer, the second passivation layer is located between the second upper electrode and the second epitaxial layer, a second opening is provided in the second passivation layer, and the second upper electrode is in contact with the second epitaxial layer through the second opening. The second upper electrode covers the top surface and the side surface of the second epitaxial layer, so that an area of the second upper electrode can be increased, and light reflection effect and heat dissipation effect are further improved.

In a possible implementation, the third primary-color light emitting diode further includes a third passivation layer; and the third upper electrode covers a top surface and a side surface of the third epitaxial layer, the third passivation layer is located between the third upper electrode and the third epitaxial layer, a third opening is provided in the third passivation layer, and the third upper electrode is in contact with the third epitaxial layer through the third opening. The third upper electrode covers the top surface and the side surface of the third epitaxial layer, so that an area of the third upper electrode can be increased, and light reflection effect and heat dissipation effect are further improved.

In a possible implementation, the display includes a plurality of pixel units. The pixel unit includes a first subpixel region, a second subpixel region, a third subpixel region, and a fourth subpixel region. The first light emission portion is located in the first subpixel region, and the first overlapping portion is located in the second subpixel region. The second light emission portion is located in the second subpixel region, the second overlapping portion is located in the third subpixel region, and the third primary-color light emitting diode is located in the third subpixel region and the fourth subpixel region. The third primary-color light emitting diode is located in the third subpixel region and the fourth subpixel region, so that a light emitting area of the third primary-color light emitting diode can be increased, and light emission effect can be improved.

In a possible implementation, a connection line between the first subpixel region and the second subpixel region intersects with a connection line between the second subpixel region and the third subpixel region. This is one layout manner.

In a possible implementation, the first primary-color light guide is located in the first subpixel region, the second primary-color light guide is located in the second subpixel region, and the third primary-color light guide is disposed in both the third subpixel region and the fourth subpixel region. Two third primary-color light guides are disposed corresponding to the third primary-color light emitting diode. This may increase a subpixel area of the third primary-color light emitting diode and improve light emitting brightness of the third primary-color light emitting diode.

According to a second aspect of embodiments of this application, a manufacturing method of a display is provided, including: forming a first primary-color light emitting diode, where the first primary-color light emitting diode includes a first overlapping portion and a first light emission portion; forming a second primary-color light emitting diode on a light emission side of the first primary-color light emitting diode, where the second primary-color light emitting diode includes a second overlapping portion and a second light emission portion, the second light emission portion covers the first overlapping portion, and the second overlapping portion exposes the first light emission portion; forming a third primary-color light emitting diode on a side that is of the second primary-color light emitting diode and that is away from the first primary-color light emitting diode, where the third primary-color light emitting diode covers the second overlapping portion and exposes the first light emission portion and the second light emission portion; forming a first primary-color light guide, where the first primary-color light guide is located on a side that is of the first light emission portion and that faces the second primary-color light emitting diode; forming a second primary-color light guide, where the second primary-color light guide is located on a side that is of the second light emission portion and that faces the third primary-color light emitting diode; and forming a third primary-color light guide, where the third primary-color light guide is located on a light emission side of the third primary-color light emitting diode.

Beneficial effects of the manufacturing method of the display provided in this embodiment of this application are the same as beneficial effects of the display. Details are not described herein again.

In a possible implementation, the forming a first primary-color light emitting diode includes: forming a first primary-color epitaxial stacked film on a carrier, where the first primary-color epitaxial stacked film includes a first quantum-well light emitting film and a first lower electrode film that are sequentially disposed on the carrier; coupling the first primary-color epitaxial stacked film to a backplane; removing the carrier; patterning the first primary-color epitaxial stacked film to form a first primary-color unit, where the first primary-color unit includes a first quantum-well light emitting layer and a first lower electrode; and forming a first upper electrode on the first primary-color unit, where the first upper electrode is in ohmic contact with the first primary-color unit to form the first primary-color light emitting diode, and the first primary-color light emitting diode includes the first lower electrode, the first quantum-well light emitting layer, and the first upper electrode.

According to a third aspect of embodiments of this application, an electronic device is provided, including a display and a circuit board, where the display is coupled to the circuit board, and the display includes the display according to any one of the first aspect.

According to a fourth aspect of embodiments of this application, a display is provided, including: a first primary-color light emitting diode and a second primary-color light emitting diode that are disposed on a substrate, where the first primary-color light emitting diode and the second primary-color light emitting diode are respectively a green light emitting diode and a blue light emitting diode; the first primary-color light emitting diode and the second primary-color light emitting diode are stacked in a thickness direction of the display; a projection of the first primary-color light emitting diode on the substrate overlaps with a projection of the second primary-color light emitting diode on the substrate; and a surface of a light emission side of the first primary-color light emitting diode is covered with a passivation layer and a metal electrode.

In a possible implementation, a surface of a light emission side of the second primary-color light emitting diode is covered with a passivation layer and a metal electrode.

In a possible implementation, a surface of a light emission side of the third primary-color light emitting diode is covered with a passivation layer and a metal electrode.

In a possible implementation, a third primary-color light emitting diode is further included, where the third primary-color light emitting diode and the second primary-color light emitting diode are stacked, and the third primary-color light emitting diode is a red light emitting diode or a blue light emitting diode; a projection of the third primary-color light emitting diode on the substrate overlaps with the projection of the second primary-color light emitting diode on the substrate; and a surface of a light emission side of the third primary-color light emitting diode is covered with a passivation layer and a metal electrode.

According to a fifth aspect of embodiments of this application, an electronic device is provided, including the display according to any one of the fourth aspect and a circuit board.

According to a sixth aspect of embodiments of this application, a manufacturing method of a display is provided, including: forming a first primary-color light emitting diode and a second primary-color light emitting diode on a substrate; forming a first light guide hole and a second light guide hole, where the first light guide hole exposes the first primary-color light emitting diode, and the second light guide hole exposes the second primary-color light emitting diode; and filling both the first light guide hole and the second light guide hole with a material having a high refractive index, to make total reflection of light.

### BRIEF DESCRIPTION OF DRAWINGS

FIG. 1A is a diagram of a framework of an electronic device according to an embodiment of this application;
FIG. 1B is a diagram of a structure of a display according to an embodiment of this application;
FIG. 2A is a diagram of a layout of a display according to an embodiment of this application;
FIG. 2B is a diagram of a structure of a pixel unit in a display according to an embodiment of this application;
FIG. 2C is a sectional view in a direction A1-A2 in FIG. 2B according to an embodiment of this application;
FIG. 2D is a diagram of a layout of pads in a pixel unit according to an embodiment of this application;
FIG. 3 to FIG. 8 are diagrams of a process of manufacturing a display according to an embodiment of this application; and
FIG. 9 is a diagram of a structure of a display according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms such as "second" and "first" below are merely for ease of description, and cannot be construed as indicating or implying relative importance or implicitly indicating a quantity of indicated technical features. Therefore, a feature limited by "second", "first", or the like may explicitly or implicitly include one or more features. In the descriptions of this application, unless otherwise stated, "a plurality of" means two or more than two.

In addition, in embodiments of this application, orientation terms such as "upper", "lower", "left", and "right" may include but are not limited to definitions based on illustrated orientations in which components in the accompanying drawings are placed. It should be understood that, these directional terms may be relative concepts, are used for description and clarification of relative positions, and may vary correspondingly depending on a change in the orientations in which the components in the accompanying drawings are placed in the accompanying drawings.

In embodiments of this application, unless otherwise clearly specified and limited, a term "connection" should be understood in a broad sense. For example, the "connection" may be a fixed connection, a detachable connection, or an integrated connection, or may be a direct connection or an indirect connection implemented through an intermediate medium. In addition, the term "coupling" may be a direct electrical connection, or may be an indirect electrical connection through an intermediate medium. The term "contact" may be direct contact or indirect contact through an intermediate medium.

In embodiments of this application, the term "and/or" describes an association relationship between associated objects and indicates that three relationships may exist. For example, A and/or B may indicate the following cases: Only A exists, both A and B exist, and only B exists, where A and B may be singular or plural. The character "/" generally indicates an "or" relationship between the associated objects.

An embodiment of this application provides an electronic device. The electronic device is, for example, a consumer electronic product, a home electronic product, a vehicle-mounted electronic product, or a financial terminal product. The consumer electronic product is, for example, a mobile phone (mobile phone), a tablet computer (pad), a notebook computer, an e-reader, a personal computer (personal computer, PC), a personal digital assistant (personal digital assistant, PDA), a desktop display, an intelligent wearable product (for example, a smart watch or a smart band), a virtual reality (virtual reality, VR) device, an augmented reality (augmented reality, AR) device, or an uncrewed aerial vehicle. The home electronic product is, for example, a smart door lock, a television, a remote control, a refrigerator, or a small rechargeable household appliance (for example, a soybean milk machine or a robot vacuum cleaner). The vehicle-mounted electronic product is, for example, a vehicle-mounted navigator or a vehicle-mounted high-density digital video disc (digital video disc, DVD). The financial terminal product is, for example, an automated teller machine (automated teller machine, ATM) or a terminal for self-service business handling.

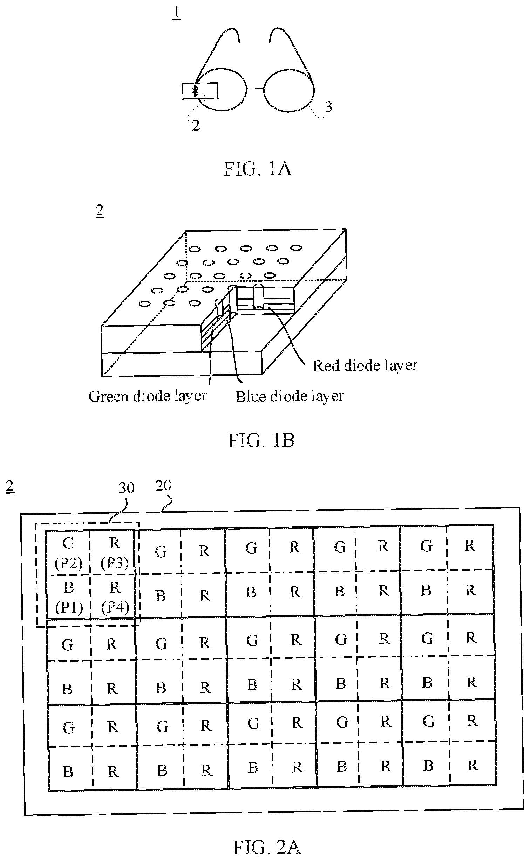

In embodiments of this application, an example in which the electronic device is augmented reality glasses (augmented reality glasses, AR glasses) is used to describe the technical solutions in embodiments of this application. FIG. 1A is a diagram of a structure of an electronic device according to an embodiment of this application. As shown in FIG. 1A, an electronic device 1 is augmented reality glasses. The electronic device 1 includes a display 2 and a frame 3, and the display 2 is fastened to the frame 3. The display 2 can be configured to display an image. The display 2 may be, for example, a micro-light emitting diode (micro-light emitting diode, Micro-LED) display.

AR glasses are considered to be a display technology that replaces a mobile phone. A solution of the micro-LED display having high brightness, a small size, and a long service life and a diffractive optical waveguide combiner is the most promising implementation of AR glasses. Due to limitations of a light emitting diode (light emitting diode, LED) manufacturing process, it is difficult to implement red, green, and blue color display on a current display. This limits application of the micro-LED display in AR glasses.

Red, green, and blue pixels of a conventional display are horizontally arranged. In high-resolution display, sizes of red, green, and blue subpixels are too small. However, after a size of the micro-LED display is reduced, light emitting efficiency of the light emitting diode (light emitting diode, LED) is sharply reduced, display brightness is reduced, and power consumption is increased.

Based on this, an embodiment of this application provides a micro-LED display. Red, green, and blue pixels are integrated in a vertical direction, so that a size of a subpixel can be properly increased. This facilitates light emitting efficiency.

FIG. 1B is a diagram of a structure of a micro-LED display according to an embodiment of this application. As shown in FIG. 1B, a micro-LED display 2 includes a blue diode layer, a red diode layer, and a green diode layer, and the blue diode layer, the red diode layer, and the green diode layer are stacked. Deep holes are dug at the blue diode layer, the red diode layer, and the green diode layer to the bottom of the corresponding diode layer. Light emitted by the diode layer is transmitted into the hole and is totally reflected in the hole to be output. Emission of three types of light: red light, green light, and blue light, that is, color display, is implemented in one pixel.

Although the micro-LED display 2 shown in FIG. 1B can implement color display, a light emission hole corresponding to the blue diode layer passes through the other two light emitting layers. This excites other light emitting layers, and easily causes light crosstalk. For example, blue light emitted by the blue diode layer is absorbed by the red diode layer, and red light is emitted, causing contamination of the blue light. In addition, a minimum size of the micro-LED display 2 is 5 µm. This cannot meet a requirement for higher resolution.

Based on this, an embodiment of this application further provides a display, to resolve a problem of light crosstalk during color display. The display may be, for example, a micro-LED display.

FIG. 2A is a diagram of an architecture of a micro-LED display according to an embodiment of this application. As shown in FIG. 2A, the micro-LED display 2 includes a backplane 20 and a plurality of pixel units 30 disposed on the backplane 20.

In some embodiments, the plurality of pixel units 30 are arranged in an array.

For example, the micro-LED display 2 has N pixel units 30 in a horizontal direction and M pixel units 30 in a vertical direction, where N and M are positive integers. For example, the 1080P micro-LED display 2 has 1920 pixel units 30 in the horizontal direction and 1080 pixel units 30 in the vertical direction.

In some embodiments, each pixel unit 30 includes four subpixels, and a size of each subpixel is 1/4 of a size of the pixel unit 30.

For example, the pixel unit 30 includes a first subpixel region P1, a second subpixel region P2, a third subpixel region P3, and a fourth subpixel region P4, and a connection line between the first subpixel region P1 and the second subpixel region P2 intersects with a connection line between the second subpixel region P2 and the third subpixel region P3.

For example, the pixel unit 30 is a rectangle, and the pixel unit 30 is divided into the first subpixel region P1, the second subpixel region P2, the third subpixel region P3, and the fourth subpixel region P4 in a 2x2 grid shape.

The pixel unit 30 includes a first primary-color subpixel, a second primary-color subpixel, and a third primary-color subpixel. The first primary-color subpixel includes a first primary-color light emitting diode, the second primary color subpixel includes a second primary-color light emitting diode, and the third primary-color subpixel includes a third primary-color light emitting diode.

The first primary-color light emitting diode, the second primary-color light emitting diode, and the third primary-color light emitting diode are stacked along a light emission side of the micro-LED display. Alternatively, it is understood as that the first primary-color light emitting diode is disposed on the backplane, the second primary-color light emitting diode is disposed on a side that is of the first primary-color light emitting diode and that is away from the backplane, and the third primary-color light emitting diode is disposed on a side that is of the second primary-color light emitting diode and that is away from the first primary-color light emitting diode.

In this embodiment of this application, a light emission side of the first primary-color light emitting diode, a light emission side of the second primary-color light emitting diode, and a light emission side of the third primary-color light emitting diode all face the light emission side of the micro-LED display.

In this embodiment of this application, the first primary-color subpixel, the second primary-color subpixel, and the third primary-color subpixel are respectively a red subpixel R, a green subpixel G, and a blue subpixel B. The red subpixel R includes a red light emitting diode, the green subpixel includes a green light emitting diode, and the blue subpixel includes a blue light emitting diode.

For example, the first primary-color subpixel is a blue subpixel B, the second primary-color subpixel is a green subpixel G, and the third primary-color subpixel is a red subpixel R. The first primary-color light emitting diode is a blue light emitting diode, the second primary-color light emitting diode is a green light emitting diode, and the third primary-color light emitting diode is a red light emitting diode.

In some embodiments, as shown in FIG. 2A, each pixel unit 30 includes a red subpixel R, a green subpixel G, and a blue subpixel B, and the red subpixel R, the green subpixel G, and the blue subpixel B are distributed in the first subpixel region P1, the second subpixel region P2, the third subpixel region P3, and the fourth subpixel region P4.

In some embodiments, as shown in FIG. 2A, a blue subpixel B is disposed in the first subpixel region P1, a green subpixel G is disposed in the second subpixel region P2, and a red subpixel R is disposed in both the third subpixel region P3 and the fourth subpixel region P4.

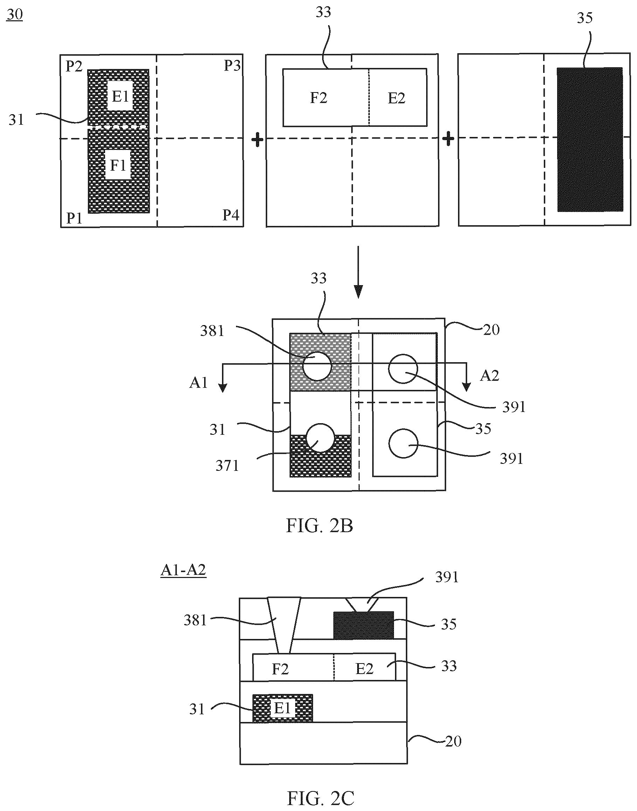

In some embodiments, as shown in FIG. 2B, the first primary-color light emitting diode 31 includes a first overlapping portion E1 and a first light emission portion F1, and the second primary-color light emitting diode 33 includes a second overlapping portion E2 and a second light emission portion F2.

The first primary-color light emitting diode 31 is located in the first subpixel region P1 and the second subpixel region P2, the second primary-color light emitting diode 33 is located in the second subpixel region P2 and the third subpixel region P3, and the third primary-color light emitting diode 35 is located in the third subpixel region P3 and the fourth subpixel region P4.

For example, the first light emission portion F1 is located in the first subpixel region P1, and the first overlapping portion E1 is located in the second subpixel region P2. The second light emission portion F2 is located in the second subpixel region P2, and the second overlapping portion E2 is located in the third subpixel region P3. The third primary-color light emitting diode 35 is located in the third subpixel region P3 and the fourth subpixel region P4.

With reference to FIG. 2B and FIG. 2C, the second light emission portion F2 of the second primary-color light emitting diode 33 covers the first overlapping portion E1 of the first primary-color light emitting diode 31, and the second overlapping portion E2 of the second primary-color light emitting diode 33 exposes the first light emission portion F2 of the first primary-color light emitting diode 31. The third primary-color light emitting diode 35 covers the second overlapping portion E2 and exposes the first light emission portion F1 and the second light emission portion F2.

Alternatively, it is understood as that a projection of the second primary-color light emitting diode 33 on the backplane 20 covers a projection of the first overlapping portion E1 on the backplane 20. A projection of the third primary-color light emitting diode 35 on the backplane 20 covers a projection of the second overlapping portion E2 on the backplane 20, and the projection of the third primary-color light emitting diode 35 on the backplane 20 does not cover a projection of the second light emission portion F2 on the backplane 20 and a projection of the first light emission portion F1 on the backplane 20.

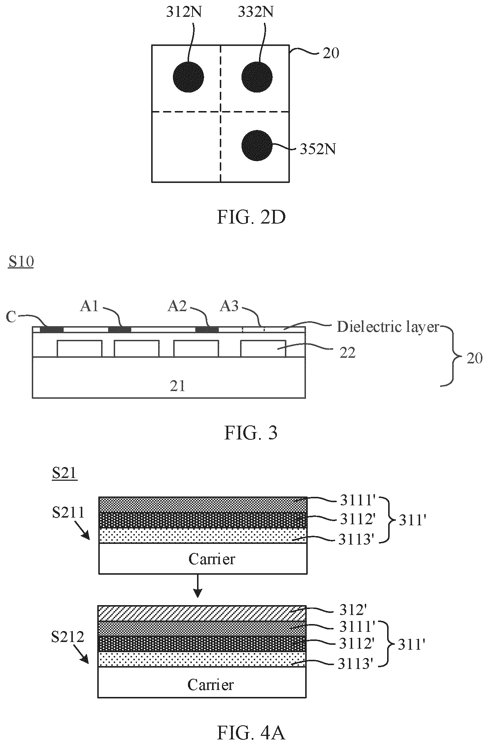

In this case, distribution of a first lower electrode pad 312N that is of the first primary-color light emitting diode 31 and that is coupled to the backplane 20, a second lower electrode pad 332N that is of the second primary-color light emitting diode 33 and that is coupled to the backplane 20, and a third lower electrode pad 352N that is of the third primary-color light emitting diode 35 and that is coupled to the backplane 20 may be shown in FIG. 2D.

In some embodiments, as shown in FIG. 2B, the pixel unit 30 further includes a first primary-color light guide hole 371, a second primary-color light guide hole 381, and a third primary-color light guide hole 391.

The first primary-color light guide hole 371 is located on a side that is of the first light emission portion F1 and that faces the second primary-color light emitting diode 33. The second primary-color light guide hole 381 is located on a side that is of the second light emission portion F2 and that faces the third primary-color light emitting diode 35. The third primary-color light guide hole 391 is located on the light emission side of the third primary-color light emitting diode 35.

Alternatively, it is understood as that, as shown in FIG. 2B, a projection of the first primary-color light guide hole 371 on the first primary-color light emitting diode 31 is located in the first light emission portion F1, a projection of the second primary-color light guide hole 381 on the second primary-color light emitting diode 33 is located in the second light emission portion F2, and a projection of the third primary-color light guide hole 391 on the third primary-color light emitting diode 35 is located in the third primary-color light emitting diode 35.

For example, the first primary-color light guide hole 371 is located in the first subpixel region P1, the second primary-color light guide hole 381 is located in the second subpixel region P2, and the third primary-color light guide hole 391 is provided in the third subpixel region P3.

Alternatively, for example, as shown in FIG. 2B, the third primary-color light guide hole 391 is provided in both the third subpixel region P3 and the fourth subpixel region P4.

In this way, the third primary-color light emitting diode 35 may have two third primary-color light guide holes 391. This may increase a subpixel area of the third primary-color light emitting diode 35 and improve light emitting brightness of the third primary-color light emitting diode 35.

In some embodiments, a first primary-color light guide is disposed in the first primary-color light guide hole 371, a second primary-color light guide is disposed in the second primary-color light guide hole 381, and a third primary-color light guide is disposed in the third primary-color light guide hole 391.

A light guide is disposed in a light guide hole, so that a refractive index at a light emission position may be increased, to improve light emission effect.

In some embodiments, the third primary-color light emitting diode 35 is a red light emitting diode.

Due to low light conversion efficiency of red light, when the red light emitting diode has two light emission holes, an area of a red light subpixel may be increased, to improve overall brightness of the display.

With reference to a manufacturing method of a micro-LED display provided in this embodiment of this application, the following describes the micro-LED display provided in this embodiment of this application by using an angle of view A1-A2 in FIG. 2B as an example.

An embodiment of this application provides a manufacturing method of a micro-LED display. The method includes the following steps.

S10: As shown in FIG. 3, provide a backplane 20.

The backplane 20 in this embodiment of this application may also be understood as a back panel on which a complementary metal-oxide-semiconductor (complementary metal-oxide-semiconductor, CMOS) drive circuit is disposed, or the backplane 20 is referred to as a thin film transistor (thin film transistor, TFT) back panel.

In some embodiments, the backplane 20 includes a substrate 21 and a drive circuit 22 disposed on the substrate 21. A material of the substrate 21 may be silicon or glass.

For example, the drive circuit 22 is prepared based on a silicon semiconductor technology.

In some embodiments, step S10 includes the following steps.

S11: Provide the substrate 21.

S12: Form the drive circuit 22 on the substrate 21.

For example, a front-end of layout (front-end of layout, FEOL) may be used to form a TFT included in the drive circuit 22, and a back-end of layout (back-end of layout, BEOL) may be used to form a wiring layer required for interconnection of the TFT and leading-out.

After the drive circuit 22 is formed, a structure of an outermost surface of the backplane 20 includes pads and a dielectric layer surrounding the pads.

For example, a top layer of the backplane 20 includes a cathode pad C, a first anode pad A1, a second anode pad A2, and a third anode pad A3.

A material of the pad may include, for example, copper (Cu), and a material of the dielectric layer may include, for example, silicon dioxide (silicon dioxide, SiO₂) and silicon nitride (silicon nitride, SiNₓ).

S20: Form a first primary-color light emitting diode 31 on the backplane 20.

For example, the first primary-color light emitting diode 31 includes a first overlapping portion E1 and a first light emission portion F1.

In some embodiments, step S20 includes the following steps.

S21: As shown in FIG. 4A, form a first primary-color epitaxial stacked film 31' on a carrier.

For example, step S21 includes the following steps.

S211: Form a first epitaxial film 311' on the carrier.

A material of the carrier includes, for example, sapphire and silicon carbide (SiC).

In some embodiments, the first epitaxial film 311' includes a first N-type semiconductor film 3111', a first quantum-well light emitting film 3112', and a first P-type semiconductor film 3113' that are sequentially stacked. That is, the first quantum-well light emitting film 3112' is located between the first N-type semiconductor film 3111' and the first P-type semiconductor film 3113'.

Both the first N-type semiconductor film 3111' and the first P-type semiconductor film 3113' are formed by doping ions in a semiconductor material. In an implementation of this application, a material of the first N-type semiconductor film 3111' and the first P-type semiconductor film 3113' may include but is not limited to any one of semiconductor materials such as gallium nitride (GaN), gallium phosphide (GaP), gallium arsenide (GaAs), silicon carbide (SiC), aluminum gallium nitride (AlGaN), or aluminum gallium indium phosphide (AlGaInP).

There are redundant electrons in the first N-type semiconductor film 3111', and there are redundant electron holes in the first P-type semiconductor film 3113'. Under an action of a current, both the redundant electrons in the first N-type semiconductor film 3111' and the redundant electron holes in the first P-type semiconductor film 3113' can move toward the first quantum-well light emitting film 3112'. In addition, the redundant electrons in the first N-type semiconductor film 3111' and the redundant electron holes in the first P-type semiconductor film 3113' are recombined in the first quantum-well light emitting film 3112' to generate photons to emit light, thereby implementing light emitting of the first epitaxial film 311'.

For example, the first epitaxial film 311' may be formed by using a molecular beam epitaxy process.

S212: Deposit a first lower electrode film 312' on the first epitaxial film 311', where the first lower electrode film 312' is in ohmic contact with the first epitaxial film 311'.

For example, the first lower electrode film 312' may be formed by using a metal-organic chemical vapor deposition process.

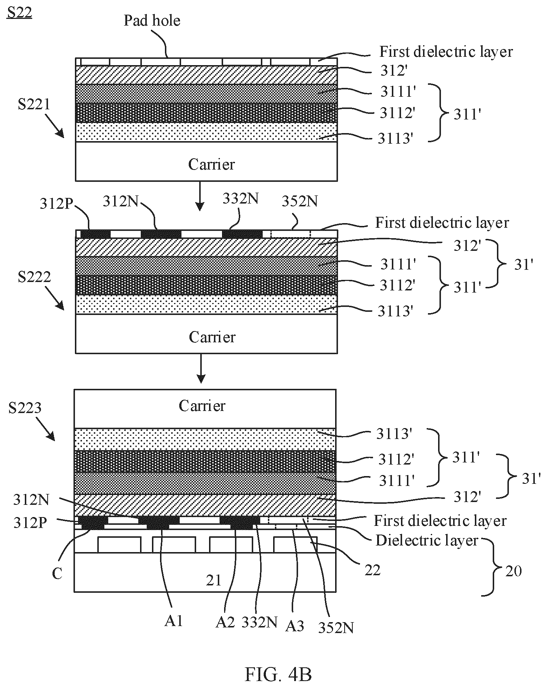

S22: As shown in FIG. 4B, couple the first primary-color epitaxial stacked film 31' to the backplane 20.

In some embodiments, step S22 includes the following steps.

S221: Deposit a first dielectric layer on the first lower electrode film 312', and form pad holes on the first dielectric layer.

In this embodiment of this application, the pad hole exposes a portion that is in the first lower electrode film 312' and that is to be used as a first lower electrode, to reserve an opening for contact between a first lower electrode pad and the first lower electrode. In addition, positions of the pad holes correspondingly match positions of the cathode pad C, the first anode pad A1, the second anode pad A2, and the third anode pad A3.

S222: Form the first lower electrode pad 312N, a first upper electrode pad 312P, a second lower electrode pad 332N, and a third lower electrode pad 352N in the pad holes, and perform chemical-mechanical planarization (chemical-mechanical planarization, CMP) processing.

After CMP processing, surface roughness of the first dielectric layer meets a bonding requirement.

S223: Bond the first dielectric layer to the backplane 20.

For example, wafer-level bonding (wafer bonding), for example, dielectric layer bonding or eutectic bonding, is used, to bond the first dielectric layer to the backplane 20. A chemical reaction occurs between the first dielectric layer on a surface of the first primary-color epitaxial stacked film 31' and the dielectric layer on a surface of the backplane 20 to form a silicon-oxide-silicon (Si-O-Si) or silicon-nitride-silicon (Si-N-Si) covalent bond, to implement bonding. Pads on the surface of the first primary-color epitaxial stacked film 31' are diffused and fused with the pads on the outermost surface of the backplane 20, to form electrical connections. A material of the pads on the surface of the first primary-color epitaxial stacked film 31' and a material of the pads on the outermost surface of the backplane 20 are both, for example, Cu, and Cu is diffused and fused with Cu, to form electrical connections.

For example, the first lower electrode pad 312N on the surface of the first primary-color epitaxial stacked film 31' is fused with the first anode pad A1 on the outermost surface of the backplane 20, the first upper electrode pad 312P is fused with the cathode pad C, the second lower electrode pad 332N is fused with the second anode pad A2, and the third lower electrode pad 352N is fused with the third anode pad A3.

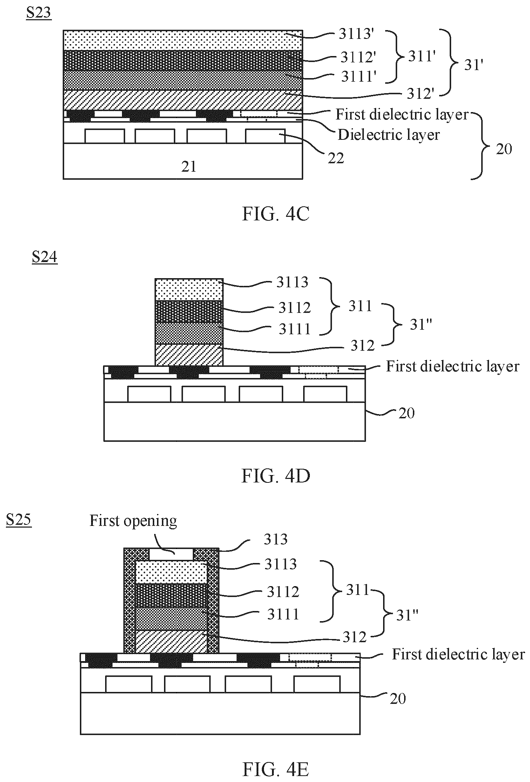

S23: As shown in FIG. 4C, remove the carrier.

S24: As shown in FIG. 4D, pattern the first primary-color epitaxial stacked film 31', to form a first primary-color unit 31".

The patterned first primary-color unit 31" includes the first dielectric layer, the first lower electrode 312, and a first epitaxial layer 311. The first epitaxial layer 311 includes a first N-type semiconductor layer 3111, a first quantum-well light emitting layer 3112, and a first P-type semiconductor layer 3113.

S25: As shown in FIG. 4E, form a first passivation layer 313 on a surface of the first primary-color unit 31".

The first passivation layer 313 covers a top surface and a side surface of the first primary-color unit 31" (the first epitaxial layer 311), the first passivation layer 313 has a first opening, and the first opening exposes a surface that is of the first primary-color unit 31" and that is away from the first lower electrode pad 312N.

The first passivation layer 313 is disposed on the surface of the first primary-color unit 31", so that passivation can be performed on the surface of the first primary-color unit 31", to reduce a surface defect of the first primary-color unit 31" and improve light emitting efficiency.

Certainly, in some embodiments, step S25 may not be performed, and step S26 is directly performed after step S24 is performed.

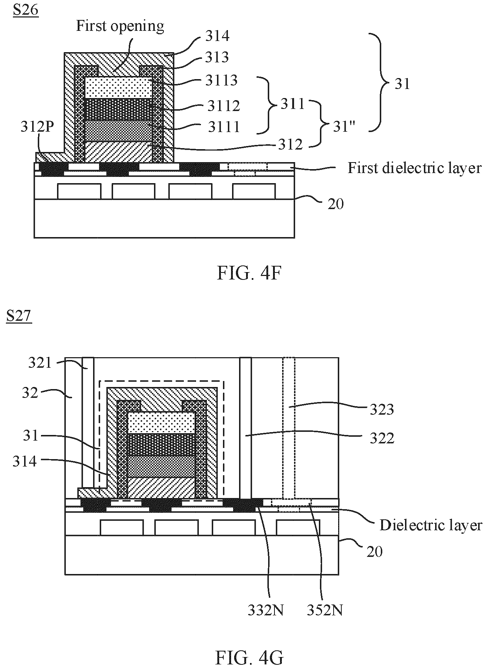

S26: As shown in FIG. 4F, form a first upper electrode 314 on a surface of the first passivation layer 313, to form the first primary-color light emitting diode 31.

In this embodiment of this application, the first primary-color light emitting diode 31 includes the first lower electrode 312, the first epitaxial layer 311, the first passivation layer 313, and the first upper electrode 314 that are sequentially disposed on the backplane 20.

The first upper electrode 314 is in ohmic contact with the first primary-color unit 31" (the first epitaxial layer 311) through the first opening on the first passivation layer 313. The first upper electrode 314 is further coupled to the first upper electrode pad 312P.

In some embodiments, a material of the first upper electrode 314 is a transparent conductive material.

In some other embodiments, the material of the first upper electrode 314 includes a conductive material having a high refractive index. For example, the material of the first upper electrode 314 includes metal.

In some embodiments, as shown in FIG. 4F, the first upper electrode 314 covers the first passivation layer 313, and is in ohmic contact with the first primary-color unit 31" through the first opening. Alternatively, it is understood as that the first upper electrode 314 covers the top surface and the side surface of the first primary-color unit 31".

The material of the first upper electrode 314 includes metal, and metal has high reflectivity, so that light emitted from the first primary-color unit 31" can be reduced, and optical interference between primary-color units can be reduced.

S27: As shown in FIG. 4G, form a first planarization layer 32 that covers the first primary-color light emitting diode 31.

In this embodiment of this application, the first planarization layer 32 is configured to prepare for bonding of the second primary-color light emitting diode.

For example, step S27 includes: forming a first flat film, and forming a first via 321, a second via 322, and a third via 323 on the first flat film, to form the first planarization layer 32.

The first planarization layer 32 covers the first primary-color light emitting diode 31, the first via 321 exposes the first upper electrode 314, the second via 322 exposes the second lower electrode pad 332N, and the third via 323 exposes the third lower electrode pad 352N.

It should be noted that, as shown in FIG. 2B, in one pixel unit 30, there are only two subpixel regions located in a same row or a same column. Therefore, in a same cross section, only structures of corresponding pads in two subpixel regions can be shown. Therefore, in FIG. 4G, a dashed line is used to represent the third via 323, because a subpixel region in which the third via 323 is located is not in a same row as subpixel regions in which the first via 321 and the second via 322 are located. Similarly, a third conductive column subsequently formed in the third via 323 and a structure coupled to the third conductive column are both represented by dashed lines, and are merely used to show a corresponding line structure for ease of understanding.

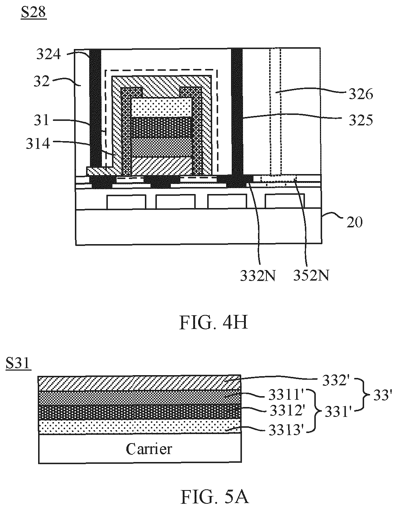

S28: As shown in FIG. 4H, form a first conductive column 324 in the first via 321, form a second conductive column 325 in the second via 322, and form a third conductive column 326 in the third via 323.

The first conductive column 324 is coupled to the first upper electrode 314, the second conductive column 325 is coupled to the second lower electrode pad 332N, and the third conductive column 326 is coupled to the third lower electrode pad 352N.

When the first conductive column 324 is coupled to the first upper electrode 314, a second upper electrode to be formed subsequently is coupled to the first upper electrode 314, and the second upper electrode and the first upper electrode 314 receive a same cathode signal, so that a structure can be simplified.

In some other embodiments, the first conductive column 324 is coupled to the first upper electrode pad 312P.

In some other embodiments, a second cathode pad is further disposed on the backplane 20, a second upper electrode pad is further disposed in the first dielectric layer, the second upper electrode pad is bonded to the second cathode pad, and the first conductive column 324 is coupled to the second upper electrode pad.

In this case, the second upper electrode to be formed subsequently and the first upper electrode 314 respectively correspond to respective cathode pads, and receive cathode signals transmitted by different pads.

In some embodiments, after the first conductive column 324, the second conductive column 325, and the third conductive column 326 are formed, CMP processing is performed on the first planarization layer 32, so that a surface of the first planarization layer 32 meets a bonding requirement.

S30: Form a second primary-color light emitting diode 33 on a light emission side of the first primary-color light emitting diode 31.

For example, the second primary-color light emitting diode 33 includes a second overlapping portion E2 and a second light emission portion F2, the second light emission portion F2 covers the first overlapping portion E1, and the second overlapping portion E2 exposes the first light emission portion F1.

For example, the foregoing process of forming the first primary-color light emitting diode 31 is repeated, to form the second primary-color light emitting diode 33.

In some embodiments, step S30 includes the following steps.

S31: As shown in FIG. 5A, form a second primary-color epitaxial stacked film 33' on the carrier.

For example, step S31 includes the following steps.

S311: Form a second epitaxial film 331' on the carrier.

In some embodiments, the second epitaxial film 331' includes a second N-type semiconductor film 3311', a second quantum-well light emitting film 3312', and a second P-type semiconductor film 3313' that are sequentially stacked. That is, the second quantum-well light emitting film 3312' is located between the second N-type semiconductor film 3311' and the second P-type semiconductor film 3313'.

Both the second N-type semiconductor film 3311' and the second P-type semiconductor film 3313' are formed by doping ions in a semiconductor material. In an implementation of this application, a material of the second N-type semiconductor film 3311' and the second P-type semiconductor film 3313' may include but is not limited to any one of semiconductor materials such as gallium nitride (GaN), gallium phosphide (GaP), gallium arsenide (GaAs), silicon carbide (SiC), aluminum gallium nitride (AlGaN), or aluminum gallium indium phosphide (AlGaInP).

There are redundant electrons in the second N-type semiconductor film 3311', and there are redundant electron holes in the second P-type semiconductor film 3313'. Under an action of a current, both the redundant electrons in the second N-type semiconductor film 3311' and the redundant electron holes in the second P-type semiconductor film 3313' can move toward the second quantum-well light emitting film 3312'. In addition, the redundant electrons in the second N-type semiconductor film 3311' and the redundant electron holes in the second P-type semiconductor film 3313' are recombined in the second quantum-well light emitting film 3312' to generate photons to emit light, thereby implementing light emitting of the second epitaxial film 331'.

In this implementation of this application, a type of the semiconductor material of the second P-type semiconductor film 3313' and the second N-type semiconductor film 3311' or a type of the ions doped in the semiconductor material is changed, so that wavelengths of the photons generated when the redundant electrons in the second N-type semiconductor film 3311' and the redundant electron holes in the second P-type semiconductor film 3313' are recombined are different, and light of different colors is generated.

S312: Deposit a second lower electrode film 332' on the second epitaxial film 331', where the second lower electrode film 332' is in ohmic contact with the second epitaxial film 331', to form the second primary-color epitaxial stacked film 33'.

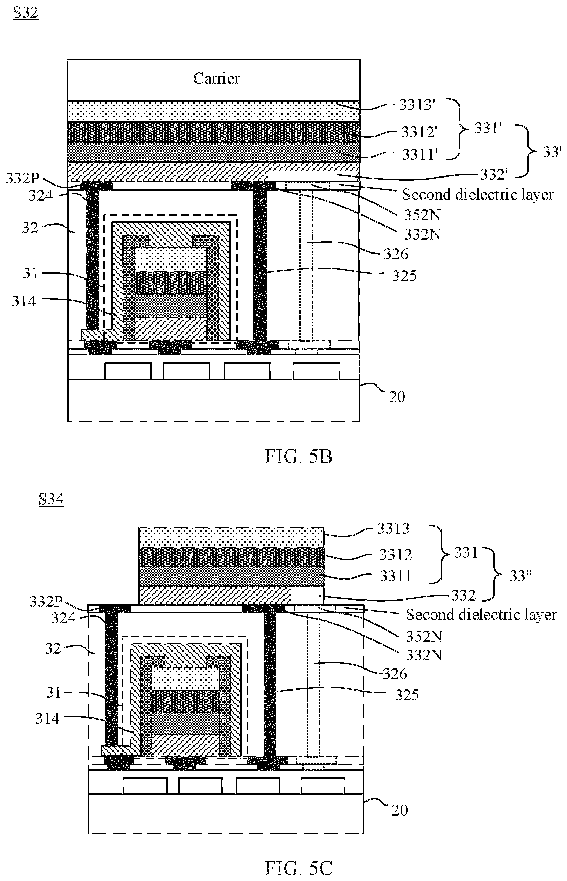

S32: As shown in FIG. 5B, couple the second primary-color epitaxial stacked film 33' to the structure formed in step S28.

In some embodiments, step S32 includes the following steps.

S321: Deposit a second dielectric layer on the second lower electrode film 332', and form pad holes on the second dielectric layer.

In this embodiment of this application, the pad hole exposes a portion that is in the second lower electrode film 332' and that is to be used as a second lower electrode, to reserve an opening for contact between the second lower electrode pad and the second lower electrode. In addition, positions of the pad holes correspondingly match positions of the first conductive column 324, the second conductive column 325, and the third conductive column 326.

S322: Form a second upper electrode pad 332P, a second lower electrode pad 332N, and a third lower electrode pad 352N in the pad holes, and perform CMP processing.

After CMP processing, surface roughness of the second primary-color epitaxial stacked film 33' meets a bonding requirement.

S323: Bond the second dielectric layer to the structure formed in step S28.

For example, wafer-level bonding is used, to bond the second dielectric layer to the structure formed in step S28. A chemical reaction occurs between the second dielectric layer on a surface of the second primary-color epitaxial stacked film 33' and the first planarization layer 32 on a surface of the structure formed in step S28 to form a silicon-oxide-silicon (Si-O-Si) or silicon-nitride-silicon (Si-N-Si) covalent bond, to implement bonding. Pads on the surface of the second primary-color epitaxial stacked film 33' are diffused and fused with the first conductive column 324, the second conductive column 325, and the third conductive column 326 of the structure formed in step S28, to form electrical connections. A material of the pads on the surface of the second primary-color epitaxial stacked film 33' and a material of the first conductive column 324, the second conductive column 325, and the third conductive column 326 are both, for example, Cu, and Cu is diffused and fused with Cu, to form electrical connections.

For example, the second upper electrode pad 332P is fused with the first conductive column 324, the second lower electrode pad 332N is fused with the second conductive column 325, and the third lower electrode pad 352N is fused with the third conductive column 326.

S33: Remove the carrier.

S34: As shown in FIG. 5C, pattern the second primary-color epitaxial stacked film 33', to form a second primary-color unit 33".

The patterned second primary-color unit 33" includes a second dielectric layer, a second lower electrode 332, and a second epitaxial layer 331. The second epitaxial layer 331 includes a second N-type semiconductor layer 3311, a second quantum-well light emitting layer 3312, and a second P-type semiconductor layer 3313.

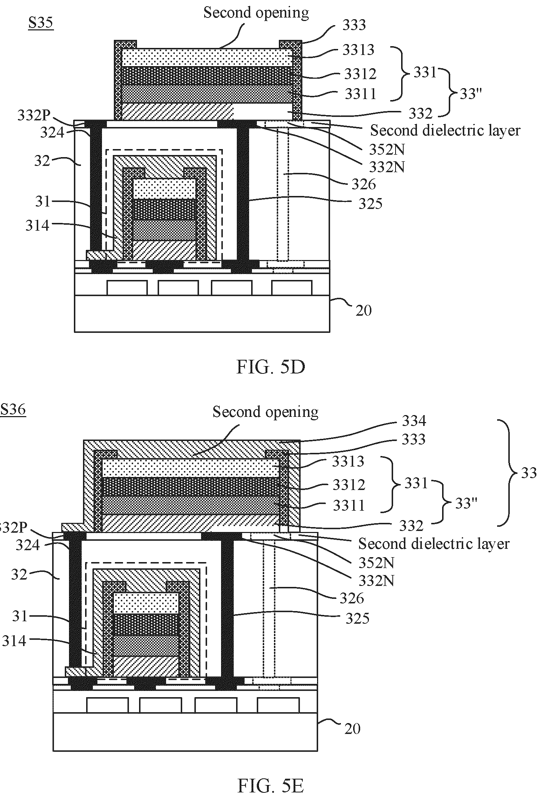

S35: As shown in FIG. 5D, form a second passivation layer 333 on a surface of the second primary-color unit 33".

The second passivation layer 333 covers a top surface and a side surface of the second primary-color unit 33" (the second epitaxial layer 331), the second passivation layer 333 has a second opening, and the second opening exposes a surface that is of the second primary-color unit 33" and that is away from the second lower electrode pad 332N.

The second passivation layer 333 is disposed on the surface of the second primary-color unit 33", so that passivation can be performed on the surface of the second primary-color unit 33", to reduce a surface defect of the second primary-color unit 33" and improve light emitting efficiency.

Certainly, in some embodiments, step S35 may not be performed, and step S36 is directly performed after step S34 is performed.

S36: As shown in FIG. 5E, form a second upper electrode 334 on a surface of the second passivation layer 333, to form the second primary-color light emitting diode 33.

In this embodiment of this application, the second primary-color light emitting diode 33 includes the second lower electrode 332, the second epitaxial layer 331, the second passivation layer 333, and the second upper electrode 334.

The second upper electrode 334 is in ohmic contact with the second primary-color unit 33" (the second epitaxial layer 331) through the second opening on the second passivation layer 333. The second upper electrode 334 is further coupled to the second upper electrode pad 332P.

In some embodiments, a material of the second upper electrode 334 is a transparent conductive material.

In some other embodiments, the material of the second upper electrode 334 includes a conductive material having a high refractive index. For example, the material of the second upper electrode 334 includes metal.

In some embodiments, as shown in FIG. 5E, the second upper electrode 334 covers the second passivation layer 333, and is in ohmic contact with the second primary-color unit 33" through the second opening. Alternatively, it is understood as that the second upper electrode 334 covers the top surface and the side surface of the second primary-color unit 33".

The material of the second upper electrode 334 includes metal, and metal has high reflectivity, so that light emitted from the second primary-color unit 33" can be reduced, and optical interference between primary-color units can be reduced.

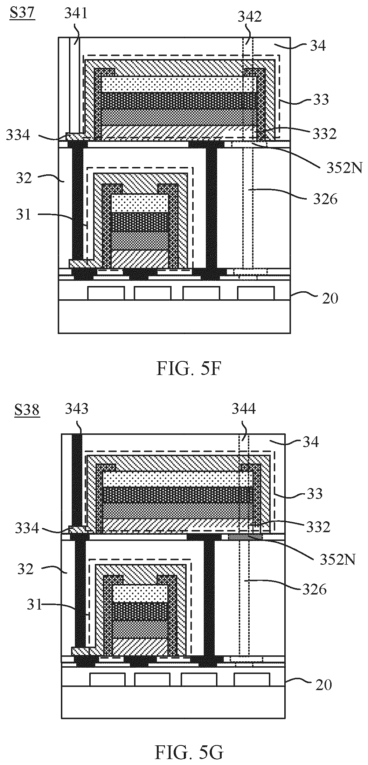

S37: As shown in FIG. 5F, form a second planarization layer 34 that covers the second primary-color light emitting diode 33.

In this embodiment of this application, the second planarization layer 34 is configured to prepare for bonding of the third primary-color light emitting diode.

For example, step S37 includes: forming a second flat film, and forming a fourth via 341 and a fifth via 342 on the second flat film, to form the second planarization layer 34.

The second planarization layer 34 covers the second primary-color light emitting diode 33, the fourth via 341 exposes the second upper electrode 334, and the fifth via 342 exposes the third lower electrode pad 352N.

It should be emphasized herein that, that the fifth via 342 in FIG. 5F passes through the second primary-color light emitting diode 33 means that, in a side view, the fifth via 342 and the second primary-color light emitting diode 33 have an overlapping portion, but in a top view, the fifth via 342 and the second primary-color light emitting diode 33 are located in different subpixel regions. In this case, similarly, the second lower electrode 332 in the second primary-color light emitting diode 33 is actually not coupled to the third lower electrode pad 352N.

S38: As shown in FIG. 5G, form a fourth conductive column 343 in the fourth via 341, and form a fifth conductive column 344 in the fifth via 342.

The fourth conductive column 343 is coupled to the second upper electrode 334, and the fifth conductive column 344 is coupled to the third lower electrode pad 352N.

When the fourth conductive column 343 is coupled to the second upper electrode 334, a third upper electrode to be formed subsequently is coupled to the fourth conductive column 343, and the third upper electrode and the fourth conductive column 343 receive a same cathode signal, so that a structure can be simplified.

In some other embodiments, the fourth conductive column 343 is coupled to the second upper electrode pad 332P.

In some other embodiments, a third cathode pad is further disposed on the backplane 20, a third upper electrode pad is further disposed in the first dielectric layer, the third upper electrode pad is bonded to the third cathode pad, and the fourth conductive column 343 is coupled to the third upper electrode pad.

In this case, the third upper electrode to be formed subsequently and the second upper electrode 334 respectively correspond to respective cathode pads, and receive cathode signals transmitted by different pads.

In some embodiments, after the fourth conductive column 343 and the fifth conductive column 344 are formed, CMP processing is performed on the second planarization layer 34, so that a surface of the second planarization layer 34 meets a bonding requirement.

S40: Form a third primary-color light emitting diode 35 on a side that is of the second primary-color light emitting diode 33 and that is away from the first primary-color light emitting diode 31.

For example, the third primary-color light emitting diode 35 covers the second overlapping portion E2 and exposes the first light emission portion F1 and the second light emission portion F2.

For example, the foregoing process of forming the second primary-color light emitting diode 33 is repeated, to form the third primary-color light emitting diode 35.

In some embodiments, step S40 includes the following steps.

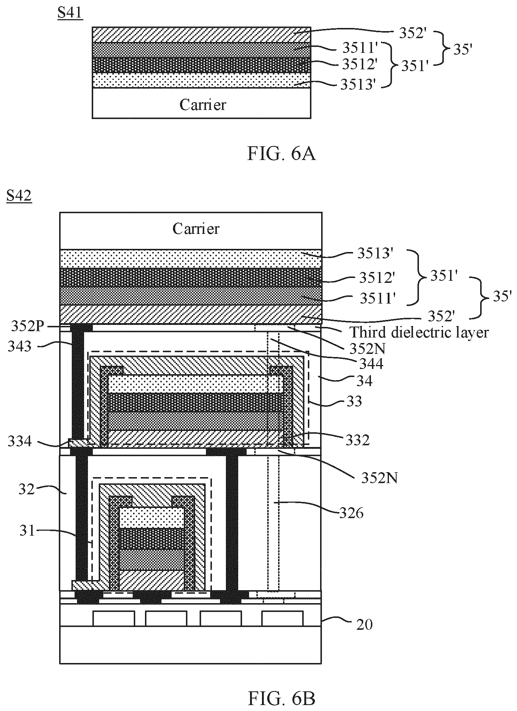

S41: As shown in FIG. 6A, form a third primary-color epitaxial stacked film 35' on the carrier.

For example, step S41 includes the following steps.

S411: Form a third epitaxial film 351' on the carrier.

In some embodiments, the third epitaxial film 351' includes a third N-type semiconductor film 3511', a third quantum-well light emitting film 3512', and a third P-type semiconductor film 3513' that are sequentially stacked. That is, the third quantum-well light emitting film 3512' is located between the third N-type semiconductor film 3511' and the third P-type semiconductor film 3513'.

Both the third N-type semiconductor film 3511' and the third P-type semiconductor film 3513' are formed by doping ions in a semiconductor material. In an implementation of this application, a material of the third N-type semiconductor film 3511' and the third P-type semiconductor film 3513' may include but is not limited to any one of semiconductor materials such as gallium nitride (GaN), gallium phosphide (GaP), gallium arsenide (GaAs), silicon carbide (SiC), aluminum gallium nitride (AlGaN), or aluminum gallium indium phosphide (AlGaInP).

There are redundant electrons in the third N-type semiconductor film 3511', and there are redundant electron holes in the third P-type semiconductor film 3513'. Under an action of a current, both the redundant electrons in the third N-type semiconductor film 3511' and the redundant electron holes in the third P-type semiconductor film 3513' can move toward the third quantum-well light emitting film 3512'. In addition, the redundant electrons in the third N-type semiconductor film 3511' and the redundant electron holes in the third P-type semiconductor film 3513' are recombined in the third quantum-well light emitting film 3512' to generate photons to emit light, thereby implementing light emitting of the third epitaxial film 351'.

In this implementation of this application, a type of the semiconductor material of the third P-type semiconductor film 3513' and the third N-type semiconductor film 3511' or a type of the ions doped in the semiconductor material is changed, so that wavelengths of the photons generated when the redundant electrons in the third N-type semiconductor film 3511' and the redundant electron holes in the third P-type semiconductor film 3513' are recombined are different, and light of different colors is generated.

S412: Deposit a third lower electrode film 352' on the third epitaxial film 351', where the third lower electrode film 352' is in ohmic contact with the third epitaxial film 351', to form the third primary-color epitaxial stacked film 35'.

S42: As shown in FIG. 6B, couple the third primary-color epitaxial stacked film 35' to the structure formed in step S38.

In some embodiments, step S42 includes the following steps.

S421: Deposit a third dielectric layer on the third lower electrode film 352', and form pad holes on the third dielectric layer.

In this embodiment of this application, the pad hole exposes a portion that is in the third lower electrode film 352' and that is to be used as a third lower electrode, to reserve an opening for contact between the third lower electrode pad and the third lower electrode. In addition, positions of the pad holes correspondingly match positions of the fourth conductive column 343 and the fifth conductive column 344.

S422: Form a third upper electrode pad 352P and a third lower electrode pad 352N in the pad holes, and perform CMP processing.

After CMP processing, surface roughness of the third primary-color epitaxial stacked film 35' meets a bonding requirement.

S423: Bond the third dielectric layer to the structure formed in step S38.

For example, wafer-level bonding is used, to bond the third dielectric layer to the structure formed in step S38. A chemical reaction occurs between the third dielectric layer on a surface of the third primary-color epitaxial stacked film 35' and the second planarization layer 34 on a surface of the structure formed in step S38 to form a silicon-oxide-silicon (Si-O-Si) or silicon-nitride-silicon (Si-N-Si) covalent bond, to implement bonding. Pads on the surface of the third primary-color epitaxial stacked film 35' are diffused and fused with the fourth conductive column 343 and the fifth conductive column 344 of the structure formed in step S38, to form electrical connections. A material of the pads on the surface of the third primary-color epitaxial stacked film 35' and a material of the fourth conductive column 343 and the fifth conductive column 344 are both, for example, Cu, and Cu is diffused and fused with Cu, to form electrical connections.

For example, the third upper electrode pad 352P is fused with the fourth conductive column 343, and the third lower electrode pad 352N is fused with the fifth conductive column 344.

S43: Remove the carrier.

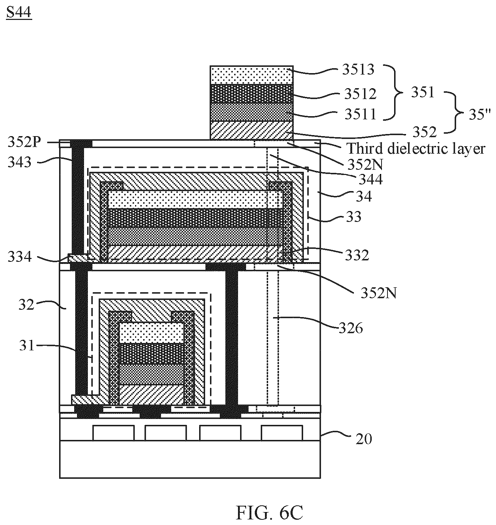

S44: As shown in FIG. 6C, pattern the third primary-color epitaxial stacked film 35', to form a third primary-color unit 35".

The patterned third primary-color unit 35" includes a third dielectric layer, a third lower electrode 352, and a third epitaxial layer 351. The third epitaxial layer 351 includes a third N-type semiconductor layer 3511, a third quantum-well light emitting layer 3512, and a third P-type semiconductor layer 3513.

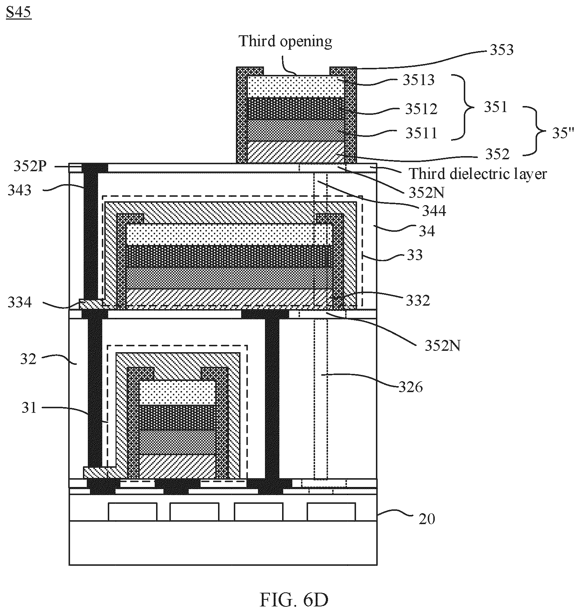

S45: As shown in FIG. 6D, form a third passivation layer 353 on a surface of the third primary-color unit 35".

The third passivation layer 353 covers a top surface and a side surface of the third primary-color unit 35" (the third epitaxial layer 351), the third passivation layer 353 has a third opening, and the third opening exposes a surface that is of the third primary-color unit 35" and that is away from the third lower electrode pad 352N.

The third passivation layer 353 is disposed on the surface of the third primary-color unit 35", so that passivation can be performed on the surface of the third primary-color unit 35", to reduce a surface defect of the third primary-color unit 35" and improve light emitting efficiency.

Certainly, in some embodiments, step S45 may not be performed, and step S46 is directly performed after step S44 is performed.

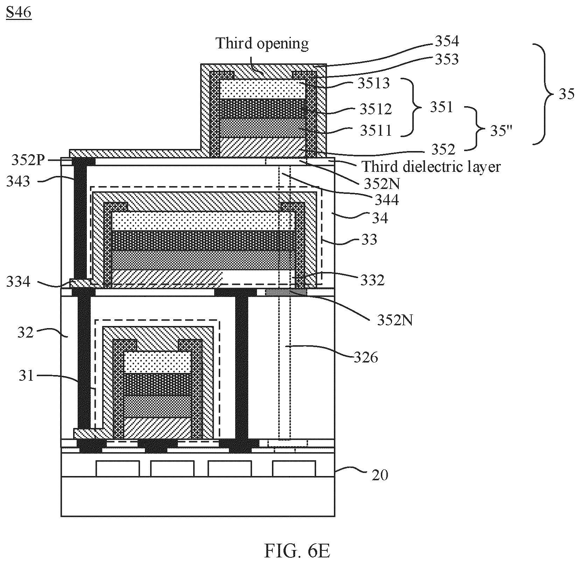

S46: As shown in FIG. 6E, form a third upper electrode 354 on a surface of the third passivation layer 353, to form the third primary-color light emitting diode 35.

In this embodiment of this application, the third primary-color light emitting diode 35 includes the third lower electrode 352, the third epitaxial layer 351, the third passivation layer 353, and the third upper electrode 354.

The third upper electrode 354 is in ohmic contact with the third primary-color unit 35" (the third epitaxial layer 351) through the third opening on the third passivation layer 353. The third upper electrode 354 is further coupled to the third upper electrode pad 352P.

In some embodiments, a material of the third upper electrode 354 is a transparent conductive material.

In some other embodiments, the material of the third upper electrode 354 includes a conductive material having a high refractive index. For example, the material of the third upper electrode 354 includes metal.

In some embodiments, as shown in FIG. 6E, the third upper electrode 354 covers the third passivation layer 353, and is in ohmic contact with the third primary-color unit 35" through the third opening. Alternatively, it is understood as that the third upper electrode 354 covers the top surface and the side surface of the third primary-color unit 35".

The material of the third upper electrode 354 includes metal, and metal has high reflectivity, so that light emitted from the third primary-color unit 35" can be reduced, and optical interference between primary-color units can be reduced.

It may be understood that, in this embodiment of this application, the first upper electrode 314, the second upper electrode 334, and the third upper electrode 354 may be coupled together, or may be independently controlled. In this embodiment of this application, an example in which the first upper electrode 314, the second upper electrode 334, and the third upper electrode 354 are coupled together is used for description. No limitation is imposed.

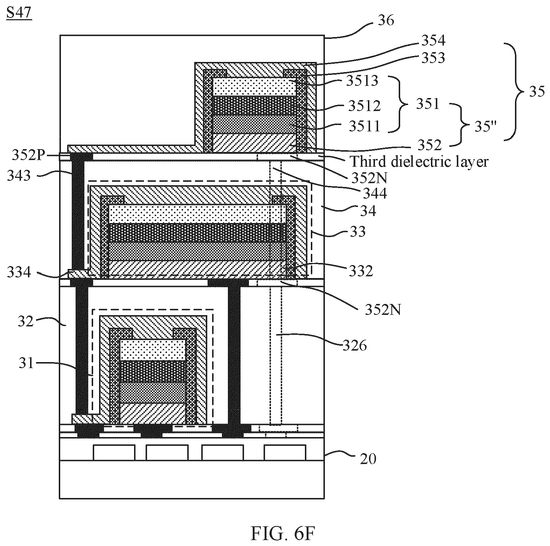

S47: As shown in FIG. 6F, form a third planarization layer 36 that covers the third primary-color light emitting diode 35.

For example, the third planarization layer 36 covers the third primary-color light emitting diode 35.

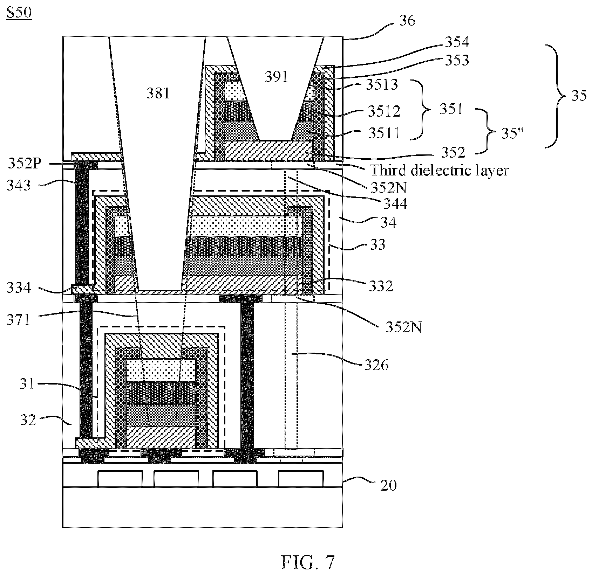

S50: As shown in FIG. 7, form a first primary-color light guide hole 371, a second primary-color light guide hole 381, and a third primary-color light guide hole 391.

In some embodiments, as shown in FIG. 7, the first primary-color light guide hole 371 passes through the third planarization layer 36, the second planarization layer 34, and the first planarization layer 32, and penetrates to the interior of the first primary-color light emitting diode 31.

For example, the first primary-color light guide hole 371 may penetrate to a surface of the first lower electrode 312 of the first primary-color light emitting diode 31.

Alternatively, for example, the first primary-color light guide hole 371 may penetrate to a surface of the first quantum-well light emitting layer 3112 of the first primary-color light emitting diode 31.

Alternatively, for example, the first primary-color light guide hole 371 may penetrate to a surface of another film layer inside the first primary-color light emitting diode 31.

In some embodiments, as shown in FIG. 7, the second primary-color light guide hole 381 passes through the third planarization layer 36 and the second planarization layer 34, and penetrates to the interior of the second primary-color light emitting diode 33.

For example, the second primary-color light guide hole 281 may penetrate to a surface of the second lower electrode 332 of the second primary-color light emitting diode 33.

Alternatively, for example, the second primary-color light guide hole 281 may penetrate to a surface of the second quantum-well light emitting layer 3312 of the second primary-color light emitting diode 33.

Alternatively, for example, the second primary-color light guide hole 281 may penetrate to a surface of another film layer inside the second primary-color light emitting diode 33.

In some embodiments, as shown in FIG. 7, the third primary-color light guide hole 391 passes through the third planarization layer 36, and penetrates to the interior of the third primary-color light emitting diode 35.

For example, the third primary-color light guide hole 391 may penetrate to a surface of the third lower electrode 352 of the third primary-color light emitting diode 35.

Alternatively, for example, the third primary-color light guide hole 391 may penetrate to a surface of the third quantum-well light emitting layer 3512 of the third primary-color light emitting diode 35.

Alternatively, for example, the third primary-color light guide hole 391 may penetrate to a surface of another film layer inside the third primary-color light emitting diode 35.

In some embodiments, a diameter of the first primary-color light guide hole 371 is 0.5 to 0.8 times a width or length of a first subpixel region P1, a diameter of the second primary-color light guide hole 381 is 0.5 to 0.8 times a width or length of a second subpixel region P2, and a diameter of the third primary-color light guide hole 391 is 0.5 to 0.8 times a width or length of a third subpixel region P3.

For example, a size of each pixel unit 30 is including 2 µm to 10 µm, and a size of a subpixel region is 1/4 of that of the pixel unit 30. When the size of the pixel unit 30 is 4 µm, the size of the subpixel region is about 1 µm, and a diameter of a light guide hole is about 500 nm to 800 nm.

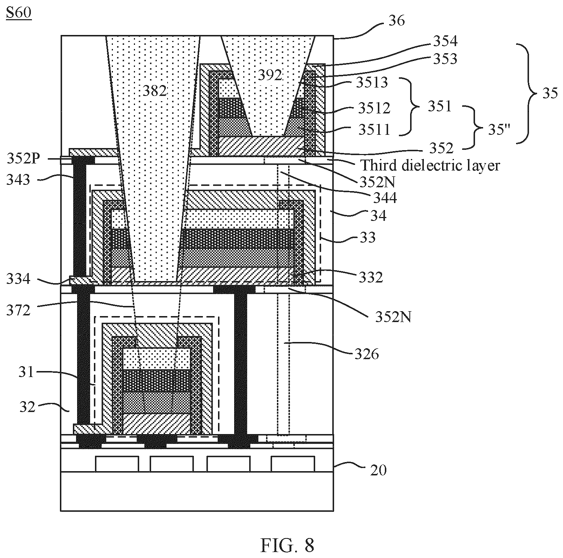

S60: As shown in FIG. 8, form a first primary-color light guide 372 in the first primary-color light guide hole 371, form a second primary-color light guide 382 in the second primary-color light guide hole 381, and form a third primary-color light guide 392 in the third primary-color light guide hole 391.

The first primary-color light guide 372 is located on a side that is of the first light emission portion F1 and that faces the second primary-color light emitting diode 33. The second primary-color light guide 382 is located on a side that is of the second light emission portion F2 and that faces the third primary-color light emitting diode 35. The third primary-color light guide 392 is located on a light emission side of the third primary-color light emitting diode 35.

In some embodiments, the first primary-color light guide 372 is located in the first primary-color light guide hole 371, the second primary-color light guide 382 is located in the second primary-color light guide hole 381, and the third primary-color light guide 392 is located in the third primary-color light guide hole 391. A material of at least one of the first primary-color light guide 372, the second primary-color light guide 382, and the third primary-color light guide 392 is a transparent material.

In this way, light guide effect of the first primary-color light guide 372, the second primary-color light guide 382, and the third primary-color light guide 392 can be improved, and a light loss can be reduced.

In some embodiments, the first primary-color light guide 372, the second primary-color light guide 382, and the third primary-color light guide 392 are made of a material having a high refractive index.

For example, a refractive index of the first primary-color light guide 372 is greater than a refractive index of at least one of the first planarization layer 32, the second planarization layer 34, and the third planarization layer 36. A refractive index of the second primary-color light guide 382 is greater than a refractive index of the second planarization layer 34 and/or the third planarization layer 36. A refractive index of the third primary-color light guide 392 is greater than a refractive index of the third planarization layer 36.

In this way, light can be emitted from the first primary-color light guide 372, the second primary-color light guide 382, and the third primary-color light guide 392 in a total reflection form, to improve light emission effect and light emission efficiency.

In some embodiments, the first primary-color light emitting diode 31, the second primary-color light emitting diode 33, and the third primary-color light emitting diode 35 are respectively a red light emitting diode, a green light emitting diode, and a blue light emitting diode.

For example, the first primary-color light emitting diode 31 is a blue light emitting diode, the second primary-color light emitting diode 33 is a green light emitting diode, and the third primary-color light emitting diode 35 is a red light emitting diode.

In this case, the first primary-color light guide 372, the second primary-color light guide 382, and the third primary-color light guide 392 are made of a transparent material having a high refractive index.

In some other embodiments, the first primary-color light emitting diode 31 and the second primary-color light emitting diode 33 are respectively a green light emitting diode and a blue light emitting diode, and the third primary-color light emitting diode 35 is a blue light emitting diode.

For example, the first primary-color light emitting diode 31 is a blue light emitting diode, the second primary-color light emitting diode 33 is a green light emitting diode, and the third primary-color light emitting diode 35 is a blue light emitting diode.

In this case, for example, the first primary-color light guide 372 and the second primary-color light guide 382 are made of a transparent material having a high refractive index. A material of the third primary-color light guide 392 includes a red light conversion material.

For example, the third primary-color light guide 392 is made of a red light conversion material having a high refractive index, and converts blue light into red light. The third primary-color light guide 392 is, for example, a quantum dot photoresist, an organic quantum dot, or a perovskite quantum dot photoresist.

The blue light emitting diode has high light emitting brightness. Red light required by the pixel unit 30 is provided by converting blue light into red light, so that light emitting brightness of the red light can be improved.

Regardless of the foregoing manners, in the micro-LED display 2 provided in this embodiment of this application, red light, green light, and blue light are guided out through light guide holes, and red light, green light, and blue light may be simultaneously emitted, to implement full-color display.

S70: Perform CMP processing on a surface of the third planarization layer 36.

In this way, surface irregularities of the micro-LED display 2 can be reduced, and surface flatness of the micro-LED display can be improved.

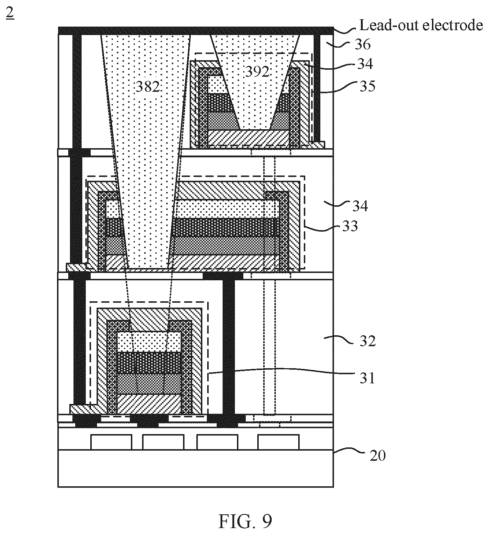

Certainly, a manner of coupling the third upper electrode 354 to the backplane 20 is not limited in embodiments of this application. FIG. 8 is merely an example. As shown in FIG. 9, a lead-out electrode may alternatively be formed on the surface of the third planarization layer 36. The lead-out electrode is coupled to the third upper electrode 354, and then is transferred downward by using a conductive column on the third planarization layer 36 to be coupled to the backplane 20.

According to the micro-LED display 2 provided in this embodiment of this application, three light emitting diodes are stacked in a thickness direction of the micro-LED display 2, so that the three light emitting diodes are arranged in a vertical direction, and a size of the light emitting diode can be increased, to improve light emitting efficiency of the light emitting diode. In addition, the three light emitting diodes are disposed in a staggered manner, no other light emitting diode is disposed above the first light emission portion F1 of the first primary-color light emitting diode 31, no other light emitting diode is disposed above the second light emission portion F2 of the second primary-color light emitting diode 33, and no other light emitting diode is disposed above the third primary-color light emitting diode 35. Therefore, the first primary-color light guide 372 passes through only the first primary-color light emitting diode 31, the second primary-color light guide 382 passes through only the second primary-color light emitting diode 33, and the third primary-color light guide 392 passes through only the third primary-color light emitting diode 35. In this way, a case in which light emitted by a plurality of primary-color light emitting diodes is guided out from a same light guide may be improved, to improve optical crosstalk between the primary-color light emitting diodes (namely, subpixels), and a requirement for high brightness in a high pixel density may be met. When the three primary-color light emitting diodes are respectively three primary color (for example, red, green, and blue) light emitting diodes, the micro-LED display 2 may further implement full-color display.

Based on this, the first upper electrode 314 covers the first epitaxial layer 311, so that light emitted by the first primary-color light emitting diode 31 may be reflected back into the first primary-color light emitting diode 31 by the first upper electrode 314. This can reduce optical interference between the primary-color light emitting diodes and improve light collection efficiency. In addition, the large-area first upper electrode 314 may improve heat dissipation effect of the first primary-color light emitting diode 31, reduce an operating temperature of the first primary-color light emitting diode 31, and improve reliability of the first primary-color light emitting diode 31, thereby improving light emitting efficiency of the first primary-color light emitting diode 31 and resolving a problem of color drifting of the first primary-color light emitting diode 31.

Similarly, the second upper electrode 334 covers the second epitaxial layer 331. This can reduce optical interference between the primary-color light emitting diodes and improve light collection efficiency. This can further improve light emitting efficiency of the second primary-color light emitting diode 33 and resolve a problem of color drifting of the second primary-color light emitting diode 33.

Similarly, the third upper electrode 354 covers the third epitaxial layer 351. This can reduce optical interference between the primary-color light emitting diodes and improve light collection efficiency. This can further improve light emitting efficiency of the third primary-color light emitting diode 35 and resolve a problem of color drifting of the third primary-color light emitting diode 35.

In addition, the micro-LED display provided in embodiments of this application has a simple manufacturing process, is easy to implement, and can be produced in batches.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A display, comprising:
a first primary-color light emitting diode, comprising a first overlapping portion and a first light emission portion;
a second primary-color light emitting diode, located on a light emission side of the first primary-color light emitting diode, wherein the second primary-color light emitting diode comprises a second overlapping portion and a second light emission portion, the second light emission portion covers the first overlapping portion, and the second overlapping portion exposes the first light emission portion;
a third primary-color light emitting diode, located on a side that is of the second primary-color light emitting diode and that is away from the first primary-color light emitting diode, wherein the third primary-color light emitting diode covers the second overlapping portion and exposes the first light emission portion and the second light emission portion;
a first primary-color light guide, located on a side that is of the first light emission portion and that faces the second primary-color light emitting diode;
a second primary-color light guide, located on a side that is of the second light emission portion and that faces the third primary-color light emitting diode; and
a third primary-color light guide, located on a light emission side of the third primary-color light emitting diode.

2. The display according to claim 1, wherein the third primary-color light emitting diode comprises a third lower electrode, a third epitaxial layer, and a third upper electrode that are sequentially stacked, and a material of the third upper electrode comprises metal.

3. The display according to claim 1 or 2, wherein the third primary-color light guide extends into the third primary-color light emitting diode.

4. The display according to any one of claims 1 to 3, wherein the display further comprises a third planarization layer located on the light emission side of the third primary-color light emitting diode; and the third primary-color light guide runs through the third planarization layer, and a refractive index of the third primary-color light guide is greater than a refractive index of the third planarization layer.

5. The display according to any one of claims 1 to 4, wherein a material of the third primary-color light guide is a transparent material.

6. The display according to any one of claims 1 to 5, wherein the third primary-color light emitting diode is a blue light emitting diode; and the material of the third primary-color light guide comprises a red light conversion material.

7. The display according to any one of claims 1 to 5, wherein the first primary-color light emitting diode, the second primary-color light emitting diode, and the third primary-color light emitting diode are respectively a red light emitting diode, a green light emitting diode, and a blue light emitting diode.

8. The display according to claim 7, wherein the third primary-color light emitting diode is the red light emitting diode.

9. The display according to any one of claims 2 to 8, wherein the third primary-color light emitting diode further comprises a third passivation layer; and
the third upper electrode covers a top surface and a side surface of the third epitaxial layer, the third passivation layer is located between the third upper electrode and the third epitaxial layer, a third opening is provided in the third passivation layer, and the third upper electrode is in contact with the third epitaxial layer through the third opening.

10. The display according to any one of claims 1 to 9, wherein the display comprises a plurality of pixel units, and the pixel unit comprises a first subpixel region, a second subpixel region, a third subpixel region, and a fourth subpixel region; and
the first light emission portion is located in the first subpixel region, the first overlapping portion is located in the second subpixel region, the second light emission portion is located in the second subpixel region, the second overlapping portion is located in the third subpixel region, and the third primary-color light emitting diode is located in the third subpixel region and the fourth subpixel region.

11. The display according to claim 10, wherein a connection line between the first subpixel region and the second subpixel region intersects with a connection line between the second subpixel region and the third subpixel region.

12. The display according to claim 10 or 11, wherein the first primary-color light guide is located in the first subpixel region, the second primary-color light guide is located in the second subpixel region, and the third primary-color light guide is disposed in both the third subpixel region and the fourth subpixel region.

13. A manufacturing method of a display, comprising:
forming a first primary-color light emitting diode, wherein the first primary-color light emitting diode comprises a first overlapping portion and a first light emission portion;
forming a second primary-color light emitting diode on a light emission side of the first primary-color light emitting diode, wherein the second primary-color light emitting diode comprises a second overlapping portion and a second light emission portion, the second light emission portion covers the first overlapping portion, and the second overlapping portion exposes the first light emission portion;
forming a third primary-color light emitting diode on a side that is of the second primary-color light emitting diode and that is away from the first primary-color light emitting diode, wherein the third primary-color light emitting diode covers the second overlapping portion and exposes the first light emission portion and the second light emission portion;
forming a first primary-color light guide, wherein the first primary-color light guide is located on a side that is of the first light emission portion and that faces the second primary-color light emitting diode;
forming a second primary-color light guide, wherein the second primary-color light guide is located on a side that is of the second light emission portion and that faces the third primary-color light emitting diode; and
forming a third primary-color light guide, wherein the third primary-color light guide is located on a light emission side of the third primary-color light emitting diode.

14. The manufacturing method according to claim 13, wherein the forming a first primary-color light emitting diode comprises:
forming a first primary-color epitaxial stacked film on a carrier, wherein the first primary-color epitaxial stacked film comprises a first quantum-well light emitting film and a first lower electrode film that are sequentially disposed on the carrier;
coupling the first primary-color epitaxial stacked film to a backplane;
removing the carrier;
patterning the first primary-color epitaxial stacked film to form a first primary-color unit, wherein the first primary-color unit comprises a first quantum-well light emitting layer and a first lower electrode; and
forming a first upper electrode on the first primary-color unit, wherein the first upper electrode is in ohmic contact with the first primary-color unit to form the first primary-color light emitting diode, and the first primary-color light emitting diode comprises the first lower electrode, the first quantum-well light emitting layer, and the first upper electrode.

15. An electronic device, comprising a display and a circuit board, wherein the display is coupled to the circuit board, and the display comprises the display according to any one of claims 1 to 12.
